Europäisches Patentamt

European Patent Office

Office européen des brevets

(19)

(11) **EP 1 253 111 A1**

(12) **EUROPEAN PATENT APPLICATION**

(43) Date of publication:
**30.10.2002 Bulletin 2002/44**

(51) Int Cl.⁷: **C01B 13/18**, C01B 13/34,
C01B 17/20, C23C 16/44,
C23C 16/448, C23C 16/453

(21) Application number: **01109979.3**

(22) Date of filing: **24.04.2001**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **Huang, Fu-Kuo
Tu-Chen City, Taipei Hsien (TW)**

(72) Inventor: **Huang, Fu-Kuo
Tu-Chen City, Taipei Hsien (TW)**

(74) Representative: **Casalonga, Axel et al
BUREAU D.A. CASALONGA - JOSSE
Paul-Heyse-Strasse 33
80336 München (DE)**

(54) **Flame synthesis and non-vacuum physical evaporation**

(57)     The invention is to implement both sol-gel process and burning process to form high quality fine or ultra fine particle powder. The particle is synthesized through high temperature flame and in extremely small dimension. Due to the high-speed synthesis, the lattice of particle or grain is oriented per its crystal habit; thus the quality of particle powder is very high.

Besides that, a physical evaporation process can be conducted in a non-vacuum environment. Except some carbon oxide, the air pollution caused by this invention will be extremely low.

This invention can provide high quality and ultra-fine particle powder and a process of non-vacuum physical evaporation with extremely low air pollution.

**EP 1 253 111 A1**

**Description**

**FIELD OF THE INVENTION**

This invention is regarding flame synthesis and non-vacuum physical evaporation. It is to implement both sol-gel process and burning process to produce high quality fine (or ultra fine) particle powder.

**BACKGROUND OF THE INVENTION**

Traditional approaches of sol-gel process to produce fine particle powder usually must place the mixed solution containing both precursor and organic solvent in an oven and slowly heat it up to the temperature slightly higher than the flash point but lower than the boiling point of the solvent. The solvent may take more than a month to be completely vaporized. After such vaporization, only the precursor is obtained, and fine particle powder has not been produced yet. Moreover, a large portion of precursor along with the solvent will be vaporized during such a long process.

As heating source is requisite to such process, the energy cost escalates relatively higher. Also because the processing time is incredibly long, not only the productivity remains low, but also the precursor will clot and cause the grains to grow larger. Thus, the particle quality is poor. Because solvent vaporization is also requisite to such process, other disadvantages of such process include low productivity, contamination, air pollution, etc.

Other approaches to produce fine particle powder include solvent vaporization, freeze drying, spray drying, thermal spraying, precipitation, hydro flame drying, etc.; However, those approaches all require higher energy cost, cause air pollution and still have barriers to produce fine particles in extremely small dimension.

**SUMMARY OF THE INVENTION**

This invention is to provide an easy and cost-effective approach for synthesis of fine (or ultra-fine) particles along with non-vacuum physical evaporation. When implementing this method, the well-formulated compound of precursor and solvent are chemically produced with an agitator, so the particles produced can all be well matched. The fine (or ultra-fine) particle powder will rapidly be synthesized when the well-mixed solution starts burning. The powder collected retains the following properties:

1. Ultra small particle dimension; and thus to be observed by TEM or SEM device only.
2. Particle surface energy is higher, and thus easier to be melted.
3. Powder can easily be stored in any proper solution.
4. Well-suited for property alteration, such as encapsulation, heterogeneous surface catalysis, etc.
5. The crystal habit of every particle is superbly consistent and much better than the particles produced by other physical processes.

During the burning process, massive well-matched fine particles will thrust through the flame and become single grains of superb lattice structure (in comparison with that produced by conventional sputtering). Meanwhile, the object to be plated can be placed at a proper distance over the flame, and massive particles or grains will deposit onto the object. This process is the non-vacuum physical evaporation.

In conventional plating processes, single metal can be plated onto the object by vacuum evaporation, but compound of bimetal or complex metal can only be plated onto the object by expensive sputtering devices. Developing new sputtering process is laborious, time-consuming, costly and thus difficult. As the fine particle powder synthesized by this invented process retains better crystal habit, the quality of plating will be higher than that of conventional methods.

As the evaporation is conducted in a non-vacuum environment, types of the material to be plated can be extended to metal, glass, porcelain, plastics, leather, fabrics, paper, etc. Without the confinement or size limit of vacuum chamber, objects to be plated can be swiveled and moved, object of very large size or with contour surface can easily be plated by this process. Further because the cost of evaporation gun is relatively low, several evaporation guns can be operated simultaneously to accelerate the speed of deposition.

**BRIEF DESCRIPTION OF THE DRAWINGS**

FIG. 1 is a diagram of a preferred embodiment of the present invention.
FIG. 2 is a diagram of another preferred practice of this invention showing particles or grains of a consistent dimension can be synthesized by this specific process.

## DETAILED DESCRIPTION OF THE PREFERRED PRACTICE

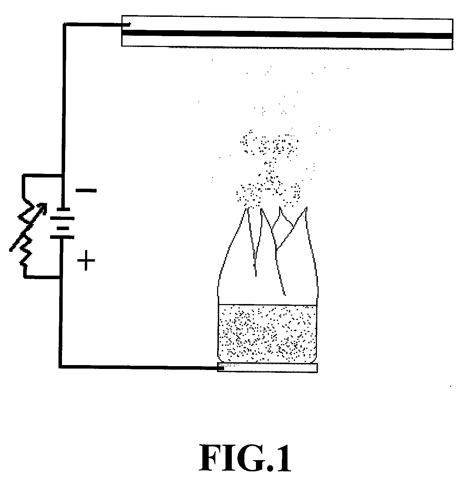

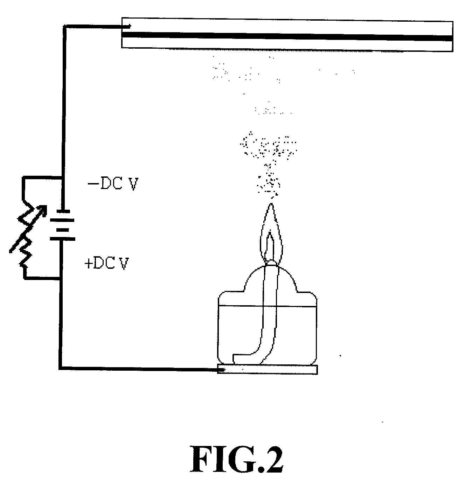

As per FIG. 1 and FIG. 2, hydride is inducted into organometallic salt for compounding reaction. Mix the solution of compound precursor with organic solvent. When the solution of precursor starts burning, the metallic compound will be co-fired with the organic solvent. Fine (or ultra-fine) particle powder can subsequently be obtained. Further, small particles as those existing in smoke can be synthesized by this process.

The hydride induced was compounded as "HnXm", and X may be individually replaced by various elements, such as oxygen, sulfur, nitrogen, boron, etc. After the burning process, the particle powder may be metal oxide, metal sulfide, metal nitride, metal borate, etc.

Examples:

$$2Al[(CH3)2CHO]3 + 3H2O ---> Al2O3 + 6(CH3)2CHOH ---- X=Oxygen$$

$$Zn[(CH3)2CHO]2 + H2S---> ZnS + 2[(CH3)2CHOH] -------- X=Sulfur$$

Besides that, if several kinds of organometallic salt are mixed or compounded by agitation and more than one kind of hydride is subsequently inducted into the solution of precursor compound. Agitate the solution for optimal compound reaction. After the burning process, particle powder of complex metal compound can be obtained.

Examples:

M = Metallic Element R = alkoxyl

$$(1) : M-OR+HX MX+HOR$$

$$(2-1): M1-OR+M2-OR M1-OR-M2----(+H2O)---> M1-O-M2+H-OR$$

$$(2-2): M1-OR+M2-OR M1(M2-OR)---(+H2O)---> M10: M2+H-OR$$

$$(2-3): M1-OR+M2-OR M2(M1-OR)---(+H2O)---> M2O: M1+H-OR$$

$$Sn[(CH3)2CHO]4+In[(CH3)2CHO]3+H2O ---> SnxInyOz+(CH3)2CHOH$$

Moreover, very complicated complex metals can also be produced in the practice of following process invented.

As several kinds of organometallic salt can be mixed or compounded by agitation, and more than one kind of hydride is subsequently inducted into the solution of precursor compound. Agitate the solution for optimal compound reaction. The first precursor in organic solvent is now ready. Use one or more different types of organometallic salt (focusing on the replacement of various metallic elements) to produce the second precursor. After the solution is completely mixed or compounded by agitation, induct one or more different types of hydride (focusing on the replacement of various non-metallic elements) into the solution and agitate it. The second precursor in organic solvent is also ready after complete agitation.

Mix the first precursor solution and the second precursor solution. Completely agitate such precursor solution then proceed the burning process. The fine (or ultra fine) particles of complicated complex metal will thrust through the flame and be synthesized.

Examples:

$$Zn[(CH3)2CHO]2+H2S ---> ZnS+2[(CH3)2CHOH$$

*(Formula 1)*

$$Eu[(CH3)2CHO]2+Dy[(CH3)2CHO]2+H2O ---> EuxDyyOz +(CH3)2CHOH$$

*(Formula 2)*

$$\{ZnS+2[(CH3)2CHOH]\} + \{EuxDyyOz+(CH3)2CHOH --->$$

$$ZnS:EuDyO+n+(CH3)2CHOH$$

*(Formula 1+2)*

By above method, different ions can easily be inter-doped.

In this invented process, metallic salt or metallic compound can be dissolved in acid or alkali to produce precursor solution, then add the proper organic solvent to produce the solution containing precursor of metallic compound and organic solvent. Proceed the burning process, the fine (or ultra-fine) particle powder or metallic compound can be produced through the co-firing process.

Examples:

Dissolve copper oxide powder (crystal phase) in hydrochloride, and the copper oxide will transform to ion precursor. This method of producing metallic compound precursor is also suitable for other metallic salt, such as metal phosphate, metal carbonate, metal sulfate, metal nitrate, etc.

Dissolve metal halide in organic solvent, or directly mix the solution of metal halide with proper solvent to produce the precursor solution of metal halide. Proceed the burning process, and the fine (or ultra fine) particle powder of metal halide can be produced through the co-firing (burning) process. For example, directly dissolve sodium chloride in ethanol and burn this solution, or dissolve sodium chloride in water to produce saturated salt water, then add massive ethanol into the salt water and burn the mixed solution.

**Claims**

1. A fine particle or ultra fine particle formation method,

   step a: mixing metal salt, ion of metal compound or precursor solution with organic solvent together into a mixed solution;
   step b: igniting to burn said metal salt or metal compound of said solution to precipitate ultra fine particle crystal with flame.

2. The method of claim 1, wherein said metal compound is metal oxide, metal sulfide, metal nitride, metal borate, metal halide, complex metal oxide, complex metal sulfide, complex metal nitride, complex metal borate or complex metal halide.

3. The method of claim 1, wherein said metal salt is metal phosphate, metal carbonate, metal sulfate, metal nitrate or organic metal salt.4.

4. The method of claim 1, wherein said more organic solvent may be added into said mixed solution to said existed organic solvent properly, enabling the density of said metal salt, said ion of metal compound, said precursor solution or said organic solvent to be adjusted, formation rate and particle size of said metal compound to be controlled, burning temperature to be increased.

5. The method of claim 1, wherein a step c may be added after said step b;

   step c: collect said fine particle powder with a powder collecting facility.

6. A non-vacuum physical evaporation, comprising following steps:

   step a: locating a workpiece above said flame of said step b of claim 1;
   step b: adjusting electric field to control the speed of said particle emitted from an electroplating gun.

# FIG.1

**FIG.2**

## EUROPEAN SEARCH REPORT

**European Patent Office**

**Application Number**

EP 01 10 9979

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | DE 43 07 333 A (MERCK PATENT GMBH) 15 September 1994 (1994-09-15) * abstract; examples 1,2 * | 1-5 | C01B13/18 C01B13/34 C01B17/20 C23C16/44 C23C16/448 C23C16/453 |
| X | US 5 958 361 A (TREADWELL DAVID R ET AL) 28 September 1999 (1999-09-28) * abstract; claim 1 * | 1 | |
| X | DE 39 16 643 C (MERCK) 3 January 1991 (1991-01-03) * claim 1 * | 1 | |
| X | WO 00 38282 A (UNIV MICHIGAN ;HINKLIN THOMAS (US); LAINE RICHARD M (US); RAND STE) 29 June 2000 (2000-06-29) * claims 5,6 * | 1 | |
| X | WO 99 29917 A (CHANG ISAAC TSZ HONG ;CHOY KWANG LEONG (GB); IMPERIAL COLLEGE (GB)) 17 June 1999 (1999-06-17) * abstract * * page 2, line 31 - page 3, line 5 * * page 4, line 8 - line 11 * | 1,6 | **TECHNICAL FIELDS SEARCHED (Int.Cl.7)** C01B C23C |
| A | WO 97 21848 A (BAI WEI ;CHOY KWANG LEONG (GB); IMPERIAL COLLEGE (GB)) 19 June 1997 (1997-06-19) * table 1 * | 1 | |

The present search report has been drawn up for all claims

| Place of search | Date of completion of the search | Examiner |
|---|---|---|
| MUNICH | 11 September 2001 | Alvazzi Delfrate, M |

EPO FORM 1503 03.82 (P04C01)

**ANNEX TO THE EUROPEAN SEARCH REPORT
ON EUROPEAN PATENT APPLICATION NO.**                    EP 01 10 9979

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2001

| Patent document cited in search report | | Publication date | Patent family member(s) | | Publication date |
|---|---|---|---|---|---|
| DE 4307333 | A | 15-09-1994 | NONE | | |
| US 5958361 | A | 28-09-1999 | US | 5614596 A | 25-03-1997 |
| | | | US | 5418298 A | 23-05-1995 |
| | | | AU | 6446294 A | 11-10-1994 |
| | | | WO | 9421712 A | 29-09-1994 |
| DE 3916643 | C | 03-01-1991 | DE | 59006848 D | 22-09-1994 |
| | | | WO | 9014307 A | 29-11-1990 |
| | | | EP | 0473621 A | 11-03-1992 |
| | | | JP | 3014442 B | 28-02-2000 |
| | | | JP | 5502008 T | 15-04-1993 |
| WO 0038282 | A | 29-06-2000 | AU | 3995700 A | 12-07-2000 |
| WO 9929917 | A | 17-06-1999 | AU | 1442199 A | 28-06-1999 |
| | | | EP | 1042531 A | 11-10-2000 |
| WO 9721848 | A | 19-06-1997 | GB | 2308132 A | 18-06-1997 |
| | | | AU | 1182997 A | 03-07-1997 |
| | | | CA | 2240625 A | 19-06-1997 |
| | | | EP | 0870075 A | 14-10-1998 |

EPO FORM P0459

For more details about this annex : see Official Journal of the European Patent Office, No. 12/82